# EUROPEAN PATENT APPLICATION

(11) **EP 3 385 408 A1**
(43) Date of publication of application: **10.10.2018**
(21) Application number: 18165789.1
(22) Date of filing: 04.04.2018
(51) Int. Cl.: C23C 28/04, C23C 14/08, C23C 16/40, C23C 28/00, C23C 4/02, C23C 4/18, C23C 4/11, C23C 4/073, C23C 4/134, F01D 5/28

(54) **THERMAL BARRIER SYSTEM WITH THIN DENSE COLUMNAR TBC LAYER AND METHODS OF FORMING THE SAME**

(30) Priority: 07.04.2017 US 201715481550
(71) Applicant: General Electric Company, Schenectady, NY 12345 (US)
(72) Inventor: CLARK, Michael David, Cincinnati, OH Ohio 45215 (US); KONITZER, Douglas Gerard, Cincinnati, OH Ohio 45215 (US)
(74) Representative: Williams, Andrew Richard

(57) **Abstract**

A coating system 102 disposed on a surface 115 of a substrate 120 is provided. The coating system may include a bond coating layer 140 on the surface of the substrate, a dense TBC layer 145 on the bond coating layer, and a columnar TBC layer 110 on the dense TBC layer, with the columnar TBC layer defines a plurality of elongated surface-connected voids 130. The dense TBC layer generally includes a ceramic material and has a porosity of about 15% or less. A method is also provided for forming a coating system on a surface of a substrate.

## Description

### FIELD

This disclosure generally relates to articles employing thermally dense TBC layers. More particularly, this disclosure relates to articles employing coatings that are resistant to degradation due to high-temperature interactions with dust materials.

### BACKGROUND

Thermal barrier coatings are typically used in articles that operate at or are exposed to high temperatures. Aviation turbines and land-based turbines, for example, may include one or more components protected by the thermal barrier coatings. Under normal conditions of operation, coated components may be susceptible to various types of damage, including erosion, oxidation, and attack from environmental contaminants.

For turbine components, environmental contaminant compositions of particular concern are those containing oxides of calcium, magnesium, aluminum, silicon, and mixtures thereof; dirt, ash, and dust ingested by gas turbine engines, for instance, are often made up of such compounds. These oxides often combine to form contaminant compositions comprising mixed calcium-magnesium-aluminum-silicon-oxide systems (Ca-Mg-Al-Si-O), hereafter referred to as "CMAS." At the high turbine operating temperatures, these environmental contaminants can adhere to the hot thermal barrier coating surface, and thus cause damage to the thermal barrier coating. For example, CMAS can form compositions that are liquid or molten at the operating temperatures of the turbines. The molten CMAS composition can dissolve the thermal barrier coating, or can fill its porous structure by infiltrating the pores, channels, cracks, or other cavities in the coating. Upon cooling, the infiltrated CMAS composition solidifies and reduces the coating strain tolerance, thus initiating and propagating cracks that may cause delamination and spalling of the coating material. This may further result in partial or complete loss of the thermal protection provided to the underlying metal substrate of the part or component. Further, spallation of the thermal barrier coating may create hot spots in the metal substrate leading to premature component failure. Premature component failure can lead to unscheduled maintenance as well as parts replacement resulting in reduced performance, and increased operating and servicing costs.

Thus, there is a need for improved coating systems that provide protection to thermal barrier coatings from the adverse effects of environmental contaminants, when operated at or exposed to high temperatures. In particular, there is a need for improved coating systems, and methods for making such coatings, that provide protection from the adverse effects of deposited CMAS.

### BRIEF DESCRIPTION

Aspects and advantages of the invention will be set forth in part in the following description, or may be obvious from the description, or may be learned through practice of the invention.

A coating system disposed on a surface of a substrate is generally provided. In one embodiment, the coating system includes a bond coating layer on the surface of the substrate, a dense TBC layer on the bond coating layer, and a columnar TBC layer on the dense TBC layer, with the columnar TBC layer defines a plurality of elongated surface-connected voids. The dense TBC layer generally includes a ceramic material and has a porosity of about 15% or less.

A method is also generally provided for forming a coating system on a surface of a substrate. In one embodiment, the method includes forming a dense TBC layer (e.g., of a ceramic material) to a porosity of about 15% or less on a bond coating layer overlying a substrate, and then applying a columnar TBC layer on the dense TBC layer such that the columnar TBC layer defines a plurality of elongated surface-connected voids.

These and other features, aspects and advantages of the present invention will become better understood with reference to the following description and appended claims. The accompanying drawings, which are incorporated in and constitute a part of this specification, illustrate aspects of the invention and, together with the description, serve to explain the principles of the invention.

### BRIEF DESCRIPTION OF THE DRAWINGS

A full and enabling disclosure of the present invention, including the best mode thereof, directed to one of ordinary skill in the art, is set forth in the specification, which makes reference to the appended Figs., in which:
FIG. 1 is a schematic cross-section illustrating one embodiment of the present invention;
FIG. 2 is a schematic cross-section illustrating another embodiment of the present invention; and
FIG. 3 is a schematic cross-section illustrating yet another embodiment of the present invention.

Repeat use of reference characters in the present specification and drawings is intended to represent the same or analogous features or elements of the present invention.

### DETAILED DESCRIPTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

As used herein, the terms "first", "second", and "third" may be used interchangeably to distinguish one component from another and are not intended to signify location or importance of the individual components.

The terms "upstream" and "downstream" refer to the relative direction with respect to fluid flow in a fluid pathway. For example, "upstream" refers to the direction from which the fluid flows, and "downstream" refers to the direction to which the fluid flows.

As used herein, the term "coating" refers to a material disposed on at least a portion of an underlying surface in a continuous or discontinuous manner. Further, the term "coating" does not necessarily mean a uniform thickness of the disposed material, and the disposed material may have a uniform or a variable thickness. The term "coating" may refer to a single layer of the coating material or may refer to a plurality of layers of the coating material. The coating material may be the same or different in the plurality of layers.

In the present disclosure, when a layer is being described as "on" or "over" another layer or substrate, it is to be understood that the layers can either be directly contacting each other or have another layer or feature between the layers, unless expressly stated to the contrary. Thus, these terms are simply describing the relative position of the layers to each other and do not necessarily mean "on top of' since the relative position above or below depends upon the orientation of the device to the viewer.

Chemical elements are discussed in the present disclosure using their common chemical abbreviation, such as commonly found on a periodic table of elements. For example, hydrogen is represented by its common chemical abbreviation H; helium is represented by its common chemical abbreviation He; and so forth.

A coating system is generally provided to protect underlying material (e.g., underlying coating and/or surfaces) from undesired chemical and/or thermal interactions. The coating system generally includes a dense thermal barrier coating layer ("dense TBC layer") between a bond coating layer and a columnar thermal barrier coating layer ("columnar TBC layer"). The dense TBC layer is meant to protect the underlying bond coating layer, and particularly any thermally grown oxide on the bond coating layer, from CMAS attack, from reactive particle attack, or reactive layer attack. The dense TBC layer is particularly useful within coating systems that include a columnar TBC layer defining a plurality of elongated surface-connected voids, such as cracks and porosity that allow access for environmental contaminants to the interior of coating, which provides a path for CMAS attack, reactive particle attack, or a reactive layer attack. Additionally or alternatively, the dense TBC layer may continue to provide thermal protection and/or protection from CMAS attack even after an impact event (e.g., a rub event) liberates the columnar TBC.

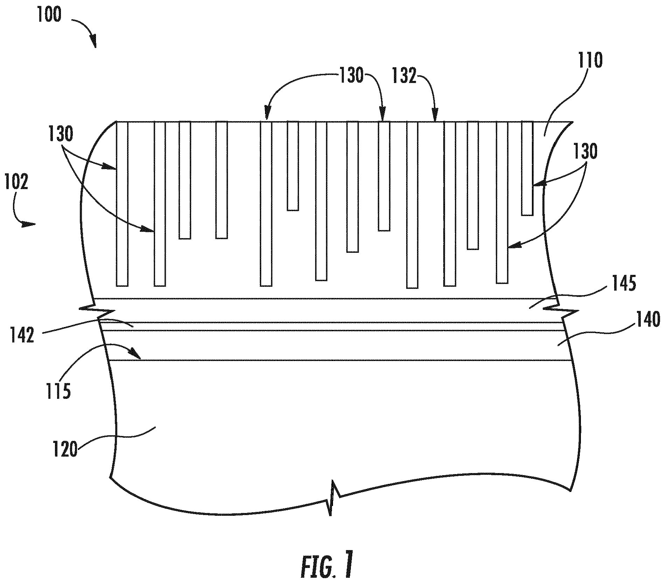

Referring to Fig. 1, an article 100 is generally shown including a coating system 102 disposed on a surface 115 of a substrate 120. The coating system 102 generally includes a bond coating layer 140 on the surface 115 of the substrate 120, a dense TBC layer 145 on the bond coating layer 140, and a columnar TBC layer 110 on the dense TBC layer 145. The columnar TBC layer 110 generally defines a plurality of elongated surface-connected voids 130. In the embodiment of Fig. 1, the columnar TBC layer 110 defines an external surface 132 of the coating system 102. Each of these layers is discussed in greater detail below.

As shown in Figs. 1, the bond coating layer 140 is disposed between coating 110 and substrate 120. Bond coating layer 140 provides functionality (adhesion promotion and oxidation resistance, for example) similar to what such coatings generally provide in conventional applications. In some embodiments, bond coating layer 140 comprises an aluminide, such as nickel aluminide, platinum aluminide, or a MCrAlY-type coating well known in the art. These bond coating layers may be especially useful when applied to a metallic substrate 120, such as a superalloy. These coatings 140 may be applied using any of various coating techniques known in the art, such as plasma spray, thermal spray, chemical vapor deposition, ion plasma deposition, vapor phase aluminide or physical vapor deposition.

The bond coating layer 140 may have a thickness of about 2.5 µm to about 400 µm and may be applied as an additive layer to the substrate 120 or may be diffused into the substrate giving an inhomogeneous composition which is engineered to have a gradient in properties. However, it is noted that all coating layers within the coating system 102 can vary in thickness depending on location on the part.

A thermally grown oxide layer 142 is shown on the bond coating layer 140. Generally, the thermally grown oxide layer 142 includes an oxide of the material of the bond coating layer 140. For example, when the bond coating layer 140 includes aluminum in its construction, the thermally grown oxide (TGO) layer 142 may include an aluminum oxide (e.g., Al₂O, AlO, Al₂O₃, etc., or mixtures thereof).

In certain embodiments, the thermally grown oxide layer 142 generally has a thickness of up to about 20 µm (e.g., about .01 µm to about 6 µm) and can be a natural product of thermal exposures during processing of subsequent layers or can be designed to be thicker by heat treating the part. The TGO layer may not be uniform dependent on the underlying bond coating layer 140, processing methods, and exposure conditions.

The dense TBC layer 145 generally has a porosity that about 15% or less (e.g., about 0.1% to about 15%), such as about 10% or less (e.g., about 0.1% to about 10%). In certain embodiments, dense TBC layer 145 generally has a porosity that about 5% or less (e.g., about 0.1% to about 5%), such as about 1% to about 5%.

In particular embodiments, the dense TBC layer 145 has a porosity gradient through its thickness. That is, the porosity of the dense TBC layer 145 may be different at the bond coating layer 140 than at columnar TBC layer 110. For example, the dense TBC layer 145 may have less porosity (i.e., more dense) near bond coating layer 140, becoming less dense as it moves away from the substrate through its thickness to the overlying columnar TBC layer 110. Such a gradient may provide more protection for CMAS near the bond coating layer 140. However, other density gradients may also be utilized in the dense TBC layer 145 as desired.

Similarly, the dense TBC layer 145 may have a compositional gradient through its thickness. That is, the composition of the dense TBC layer 145 may be different at the bond coating layer 140 than at columnar TBC layer 110. For example, the dense TBC layer 145 may have a first composition near bond coating layer 140, that changes as it moves away from the substrate through its thickness to the overlying columnar TBC layer 110. Such a compositional gradient may be utilized to provide protection for CMAS, such as by having a CMAS reactive material at the outer parts of the thickness (near the columnar TBC layer 110) with a more stable, non-reactive material near the bond coating layer 140 so as to not react with the bond coating layer 140 and/or TGO layer 142. However, other compositional gradients may also be utilized in the dense TBC layer 145 as desired.

The structure of the dense TBC layer 145, in particular embodiments, minimizes the access of contaminants through any vertical cracks or connected porosity so that the coating system 102 performs as a barrier to infiltration through the more porous columnar TBC layer 110. In one embodiment, the barrier layer 145 is manufactured with a process that creates equi-axed pores to have less than 15% porosity so as to decrease connected porosity, as discussed above. For example, the dense TBC layer may have a density of about 1 g/cm³ to about 5 g/cm³. The viscosity of the processing solution can determine the density/porosity requirements of the dense TBC layer.

The thickness of the dense TBC layer 145 may depend upon the substrate 120 on which it is deposited, and/or the type of component formed from the article 100. In particular embodiments, the thickness of dense TBC layer 145 may depend upon the thickness of the overlaying columnar TBC layer 110, but is typically less than half of the total thickness of the coating system 102. In some embodiments, the columnar TBC layer 110 is about 4 times to about 8 times thicker than the dense TBC layer 145 (i.e., the dense TBC layer 145 has a thickness that is about 1/4^{th} to about 1/8^{th} of the thickness of the columnar TBC layer 110) to provide sufficient barrier for the particular columnar TBC layer 110 thereon. For example, with the columnar TBC layer 110 has a thickness of about about 25 microns to about 2000 microns, the dense TBC layer 145 may have a thickness of about 4 microns to about 335 microns.

The dense TBC layer 145 may be applied using any of various coating techniques known in the art to achieve the desired porosity, such as plasma spray, thermal spray, chemical vapor deposition, or physical vapor deposition. In one embodiment, the dense TBC layer 145 is formed by a two-step deposition process that back-fills the initial porosity of the first deposition process in order to increase the density of the resulting TBC layer 145 (i.e., decreases the initial porosity by filling the holes with additional material). For example, the TBC layer 145 may be formed by slurry deposition and melt infiltration.

The dense TBC layer 145 generally includes a ceramic thermal barrier material, or a combination of ceramic thermal barrier materials. That is, two or more ceramic thermal barrier materials may be co-sprayed onto the substrate 102 to form the dense TBC layer 145. The selected composition of dense TBC layer 145 may depend upon one or factors, including the composition of the adjacent bond coating layer 140, the coefficient of thermal expansion (CTE) characteristics desired for the dense TBC layer 145, and the thermal barrier properties desired for dense TBC layer 145.

For example, the materials for the dense TBC layer 145 include various types of oxides, such as hafnium oxide ("hafnia") or zirconium oxide ("zirconia"), in particular stabilized hafnia or stabilized zirconia, and blends including one or both of these. Examples of stabilized zirconia include without limitation yttria-stabilized zirconia, ceria-stabilized zirconia, calcia-stabilized zirconia, scandia-stabilized zirconia, magnesia-stabilized zirconia, india-stabilized zirconia, ytterbia-stabilized zirconia, lanthana-stabilized zirconia, gadolinia-stabilized zirconia, as well as mixtures of such stabilized zirconia. Similar stabilized hafnia compositions are known in the art and suitable for use in embodiments described herein.

In certain embodiments, dense TBC layer 145 includes yttria-stabilized zirconia. Suitable yttria-stabilized zirconia may include from about 1 weight percent to about 20 weight percent yttria (based on the combined weight of yttria and zirconia), and more typically from about 3 weight percent to about 10 weight percent yttria. An example yttria-stabilized zirconia columnar TBC layer includes about 7% yttria and about 93% zirconia. These types of zirconia may further include one or more of a second metal (e.g., a lanthanide or actinide) oxide, such as dysprosia, erbia, europia, gadolinia, neodymia, praseodymia, urania, and hafiiia, to further reduce thermal conductivity of the dense TBC layer 145 material. In some embodiments, the dense TBC layer 145 material may further include an additional metal oxide, such as, titania.

Suitable ceramic dense TBC layer 145 materials may also include pyrochlores of general formula A₂B₂O₇ where A is a metal having a valence of 3+ or 2+ (e.g., gadolinium, aluminum, cerium, lanthanum or yttrium) and B is a metal having a valence of 4+ or 5+ (e.g., hafnium, titanium, cerium or zirconium) where the sum of the A and B valences is 7. Representative materials of this type include gadolinium zirconate, lanthanum titanate, lanthanum zirconate, yttrium zirconate, lanthanum hafnate, cerium hafnate, and lanthanum cerate.

Dense TBC layer 145 may include the ceramic columnar TBC layer material in an amount of up to 100 weight percent. In some embodiments, the dense TBC layer 145 includes the ceramic columnar TBC layer material in a range from about 95 weight percent to about 100 weight percent and more particularly from about 98 weight percent to about 100 weight percent.

Referring again to FIG. 1, the columnar TBC layer 110 is disposed on the dense TBC layer 145 over the bond coating layer 110 and the substrate 120. The columnar TBC layer 110 includes surface-connected voids 130 such as cracks and porosity that allow for thermal expansion and contraction of the columnar TBC layer 110 to protect the coating system 102 against extreme thermal changes. However, as discussed above, the surface-connected voids 130 of the columnar TBC layer 130 also allows access for environmental contaminants to the interior of coating 110, possibly to the underlying dense TBC layer 145. Typically, the voids 130 are elongated through the thickness of the columnar TBC layer 130. That is, the voids 130 have an aspect ratio higher than 1, and are often oriented such that contaminants entering the void 130 can be conducted into the cross-sectional thickness of the coating 110. In some embodiments, voids 130 include substantially vertically oriented (from the perspective of a cross-sectional view as in Fig. 1) cracks and/or boundaries of grains or other microstructural features. These voids 130 may be present due to inherent characteristics of deposition processes used to deposit the coating 110; some voids 130 may also form after deposition due to normal wear and tear during operation.

Columnar TBC layer 110 may be applied by any technique suitable for a given application. Coatings that are deposited by air plasma spray techniques, for instance, may result in a sponge-like porous structure of open pores in at least the surface of the coating. Under certain deposition conditions, well developed, vertically oriented (relative to the plane of the substrate/coating interface) cracks are also formed by plasma spraying columnar TBC layer materials. Similarly, columnar TBC layers that are deposited by physical- or chemical- vapor deposition techniques may result in a structure including a series of columnar grooves, crevices or channels in at least the surface of the coating. A porous structure, especially (though not exclusively) a structure incorporating vertically oriented and/or columnar features as noted above, may be one of the factors that provides for strain tolerance by the columnar TBC layers during thermal cycling. Further, the porous structure may provide for stress reduction due to the differences between the coefficient of thermal expansion (CTE) of the coating and the CTE of the underlying bond coat layer/substrate.

Columnar TBC layer 110 generally includes a ceramic thermal barrier material, which may be independently selected from the ceramic material of the dense TBC layer 145. That is, in certain embodiments, the ceramic material of the dense TBC layer 145 and the columnar TBC layer 110 are substantially identical in terms of chemical composition. However, in other embodiments, the ceramic material of the dense TBC layer 145 and the columnar TBC layer 110 are different in terms of chemical composition. Suitable ceramic columnar TBC layer 110 materials include various types of oxides, such as hafnium oxide ("hafnia") or zirconium oxide ("zirconia"), in particular stabilized hafnia or stabilized zirconia, and blends including one or both of these. Examples of stabilized zirconia include without limitation yttria-stabilized zirconia, ceria-stabilized zirconia, calcia-stabilized zirconia, scandia-stabilized zirconia, magnesia-stabilized zirconia, india-stabilized zirconia, ytterbia-stabilized zirconia, lanthana-stabilized zirconia, gadolinia-stabilized zirconia, as well as mixtures of such stabilized zirconia. Similar stabilized hafnia compositions are known in the art and suitable for use in embodiments described herein.

In certain embodiments, columnar TBC layer 110 includes yttria-stabilized zirconia. Suitable yttria-stabilized zirconia may include from about 1 weight percent to about 20 weight percent yttria (based on the combined weight of yttria and zirconia), and more typically from about 3 weight percent to about 10 weight percent yttria. An example yttria-stabilized zirconia columnar TBC layer includes about 7% yttria and about 93% zirconia. These types of zirconia may further include one or more of a second metal (e.g., a lanthanide or actinide) oxide, such as dysprosia, erbia, europia, gadolinia, neodymia, praseodymia, urania, and hafnia, to further reduce thermal conductivity of the columnar TBC layer material. In some embodiments, the columnar TBC layer material may further include an additional metal oxide, such as, titania.

Suitable ceramic columnar TBC layer materials may also include pyrochlores of general formula A₂B₂O₇ where A is a metal having a valence of 3+ or 2+ (e.g., gadolinium, aluminum, cerium, lanthanum or yttrium) and B is a metal having a valence of 4+ or 5+ (e.g., hafnium, titanium, cerium or zirconium) where the sum of the A and B valences is 7. Representative materials of this type include gadolinium zirconate, lanthanum titanate, lanthanum zirconate, yttrium zirconate, lanthanum hafnate, cerium hafnate, and lanthanum cerate.

Columnar TBC layer 110 may include the ceramic columnar TBC layer material in an amount of up to 100 weight percent. In some embodiments, the columnar TBC layer 110 includes the ceramic columnar TBC layer material in a range from about 95 weight percent to about 100 weight percent and more particularly from about 98 weight percent to about 100 weight percent. The selected composition of coating 110 may depend upon one or factors, including the composition of the optional, adjacent dense TBC layer 145, the coefficient of thermal expansion (CTE) characteristics desired for coating 110, and the thermal barrier properties desired for coating 110.

The thickness of columnar TBC layer 110 may depend upon the substrate or the component it is deposited on. In some embodiments, columnar TBC layer 110 has a thickness that is greater than the thickness of the dense TBC layer 145. For example, the columnar TBC layer 110 may have a thickness in a range of from about 25 microns to about 2000 microns. In some embodiments, coating 110 has a thickness in a range of from about 25 microns to about 1500 microns. In some embodiments, the thickness is in a range of from about 25 microns to about 1000 microns.

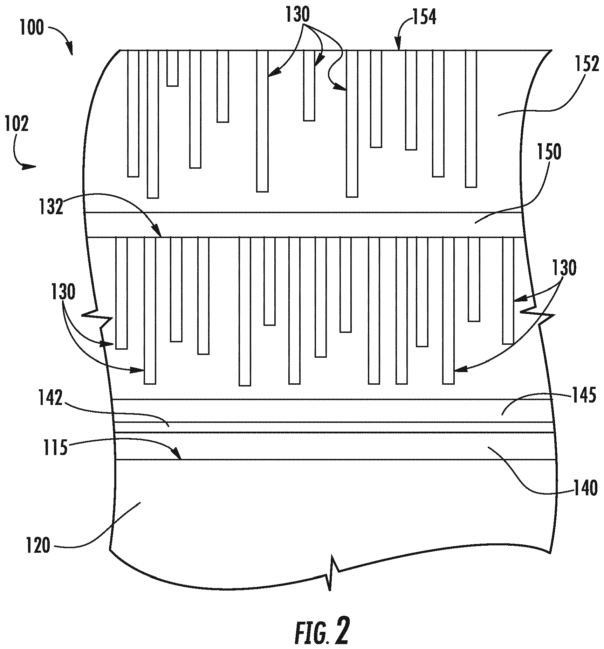

In certain embodiments, multiple dense TBC layers and multiple columnar TBC layers may be present within the coating system 102. In such an embodiment, the coating system may allow for additional CMAS protection to the underlying substrate 102. Additionally the coating system with multiple layers may protect the underlying layers in the event of damage to the outer coating layers (e.g., after a rub event). For example, the coating system 102 may include at least two dense TBC layers and two columnar TBC layers, in alternating arrangement. Referring to Fig. 2, the coating system 102 is similar to the coating system of Fig. 2, with the addition of an outer dense TBC layer 150 and an outer columnar TBC layer 152 that defines an external surface 154 of the coating system 102.

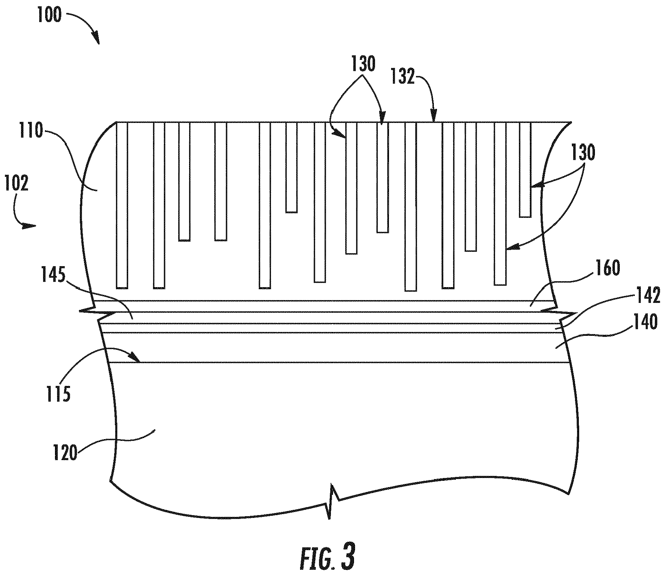

In still further embodiments, such as shown in Fig. 3, an intermediate dense layer 160 may be present between the dense TBC layer 145 and the columnar TBC layer 110. The intermediate dense layer 160 a porosity of about 15% or less (e.g., about 0.1% to about 15%), such as about 10% or less (e.g., about 0.1% to about 10%). In certain embodiments, dense TBC layer 145 generally has a porosity that about 5% or less (e.g., about 0.1% to about 5%), such as about 1% to about 5%.

The intermediate dense layer 160 generally includes a ceramic thermal barrier material, which may be independently selected from the ceramic material of the dense TBC layer 145 and/or the columnar TBC layer 110. That is, in certain embodiments, the ceramic material of the intermediate dense layer 160, the dense TBC layer 145, and/or the columnar TBC layer 110 are substantially identical in terms of chemical composition. However, in other embodiments, the ceramic material of the intermediate dense layer 160 is different in terms of chemical composition than either or both of the dense TBC layer 145 and the columnar TBC layer 110.

In one particular embodiment, the intermediate dense layer 160 includes gadolinium, such as in the form of a gadolinia-stabilized zirconia (e.g., gadolinium zirconate), A₂B₂O₇ where A is a gadolinium having a valence of 3+ or 2+, B is a metal having a valence of 4+ or 5+ (e.g., hafnium, titanium, cerium or zirconium) with the sum of the A and B valences is 7. Such a gadolinium-containing intermediate dense layer 160 that provides good CMAS protection for the coating system 102, but is reactive with the underlying bond coating 140. Thus, the dense TBC layer 145 protects the bond coating 140 from the gadolinium included in the intermediate dense layer 160.

The thickness of the intermediate dense layer 160 may depend upon the substrate 120 on which it is deposited, and/or the type of component formed from the article 100. In particular embodiments, the thickness of intermediate dense layer 160 may depend upon the thickness of the overlaying columnar TBC layer 110, but is typically less than half of the total thickness of the coating system 102. In some embodiments, the columnar TBC layer 110 is about 4 times to about 8 times thicker than the intermediate dense layer 160 (i.e., the intermediate dense layer 160 has a thickness that is about 1/4^{th} to about 1/8^{th} of the thickness of the columnar TBC layer 110) to provide sufficient barrier for the particular columnar TBC layer 110 thereon. For example, with the columnar TBC layer 110 has a thickness of about about 25 microns to about 2000 microns, the intermediate dense layer 160 may have a thickness of about 4 microns to about 335 microns.

The intermediate dense layer 160 may be applied using any of various coating techniques known in the art to achieve the desired porosity, such as plasma spray, thermal spray, chemical vapor deposition, or physical vapor deposition. In one embodiment, the intermediate dense layer 160 is formed by a two-step deposition process that back-fills the initial porosity of the first deposition process in order to increase the density of the resulting intermediate dense layer 160 (i.e., decreases the initial porosity by filling the holes with additional material).

Methods are also generally provided for forming a coating system on the surface of a substrate in order to make articles, such as article 100 described above. As noted previously, a dense TBC layer 142 may be formed on a bond coating layer overlying a substrate by any of several different coating techniques, such as plasma spray techniques (for example, air plasma spray using dry or liquid feedstock materials), chemical vapor deposition, physical vapor deposition (for example, electron-beam physical vapor deposition or evaporation), slurry deposition, sol-gel techniques, and other coating methods. Also as discussed above, such a dense TBC layer 142 may be formed by first applying the ceramic material onto the bond coating layer to have an initial porosity, and then backfilling the ceramic material applied on the bond coating layer to increase the density to form the dense TBC layer. In certain embodiments, the method may also include forming an intermediate dense layer on the dense TBC layer prior to forming the columnar TBC layer, such as a gadolinium-containing intermediate dense layer, as described above.

The coating system 102 is generally disposed on a surface 115 of the substrate 120 to form an article 100. In particular embodiments, the article 100 may be any component that is subject to service in a high-temperature environment, such as a component of a gas turbine assembly (e.g., within a). Examples of such components include, but are not limited to, components that include turbine airfoils such as blades and vanes, and combustion components such as liners and transition pieces. Substrate 120, then, may be any material suitable for use in such applications; examples include nickel-base superalloys, cobalt-base superalloys, and ceramic matrix composites, to name a few.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A coating system disposed on a surface of a substrate, the coating system comprising:
   a bond coating layer on the surface of the substrate;
   a dense TBC layer on the bond coating layer, wherein the dense TBC layer comprises a ceramic material, and wherein the dense TBC layer has a porosity of about 15% or less; and
   a columnar TBC layer on the dense TBC layer, wherein the columnar TBC layer defines a plurality of elongated surface-connected voids.
2. The coating system as in clause 1, wherein the ceramic material comprises hafnium oxide, zirconium oxide, or a mixture thereof.
3. The coating system as in any preceding clause, wherein the ceramic material comprises a stabilized hafnium oxide, a stabilized zirconium oxide, or a mixture thereof.
4. The coating system as in any preceding clause, wherein the ceramic material comprises a yttria-stabilized zirconia, a ceria-stabilized zirconia, a calcia-stabilized zirconia, a scandia-stabilized zirconia, a magnesia-stabilized zirconia, an india-stabilized zirconia, an ytterbia-stabilized zirconia, a lanthana-stabilized zirconia, a gadolinia-stabilized zirconia, or a mixture thereof.
5. The coating system as in any preceding clause, wherein the columnar TBC layer has a thickness of about 25 microns to about 2000 microns.
6. The coating system as in any preceding clause, wherein the dense TBC layer has a thickness that is about half of the thickness of the columnar TBC layer, or less.
7. The coating system as in any preceding clause, wherein the dense TBC layer has a thickness that is about 1/4^{th} to about 1/8^{th} of the thickness of the columnar TBC layer.
8. The coating system as in any preceding clause, wherein the dense TBC layer has a porosity of about 0.1% to about 10%.
9. The coating system as in any preceding clause, further comprising:
   a thermally grown oxide on the bond coating layer, wherein the thermally grown oxide is positioned between the bond coating layer and the dense TBC layer.
10. The coating system as in any preceding clause, further comprising:
   an intermediate dense layer positioned between the dense TBC layer and the columnar TBC layer.
11. The coating system as in any preceding clause, wherein the intermediate dense layer is a gadolinium-containing intermediate dense layer.
12. The coating system as in any preceding clause, wherein the intermediate dense layer has a porosity that is about 15% or less.
13. The coating system as in any preceding clause, wherein the intermediate dense layer has a thickness that is about half of the thickness of the columnar TBC layer, or less.
14. The coating system as in any preceding clause, wherein the intermediate dense layer has a thickness that is about 1/4^{th} to about 1/8^{th} of the thickness of the columnar TBC layer.
15. The coating system as in any preceding clause, wherein the intermediate dense layer has a porosity of about 0.1 % to about 10%.
16. The coating system as in any preceding clause, further comprising:
   an outer dense TBC layer on the columnar TBC layer; and
   an outer columnar TBC layer on the outer dense TBC layer.
17. A method of forming a coating system on a surface of a substrate, the method comprising:
   forming a dense TBC layer on a bond coating layer overlying a substrate, wherein the dense TBC layer comprises a ceramic material, and wherein the dense TBC layer is formed to a porosity of about 15% or less; and
   applying a columnar TBC layer on the dense TBC layer such that the columnar TBC layer defines a plurality of elongated surface-connected voids.
18. The method as in any preceding clause, wherein forming the dense TBC layer comprises:
   applying the ceramic material onto the bond coating layer to have an initial porosity; and
   backfilling the ceramic material applied on the bond coating layer to increase the density to form the dense TBC layer.
19. The method as in any preceding clause, further comprising:
   forming an intermediate dense layer on the dense TBC layer prior to forming the columnar TBC layer.
20. The method as in any preceding clause, wherein the intermediate dense layer is a gadolinium-containing intermediate dense layer.

## Claims

1. A coating system (102) disposed on a surface (115) of a substrate (120), the coating system comprising:
a bond coating layer (140) on the surface of the substrate;
a dense TBC layer (145) on the bond coating layer, wherein the dense TBC layer comprises a ceramic material, and wherein the dense TBC layer has a porosity of about 15% or less; and
a columnar TBC layer (110) on the dense TBC layer, wherein the columnar TBC layer defines a plurality of elongated surface-connected voids (130).

2. The coating system (102) as in claim 1, wherein the ceramic material comprises hafnium oxide, zirconium oxide, or a mixture thereof.

3. The coating system (102) as in either of claim 1 or 2, wherein the ceramic material comprises a stabilized hafnium oxide, a stabilized zirconium oxide, or a mixture thereof.

4. The coating system (102) as in any preceding claim, wherein the ceramic material comprises a yttria-stabilized zirconia, a ceria-stabilized zirconia, a calcia-stabilized zirconia, a scandia-stabilized zirconia, a magnesia-stabilized zirconia, an india-stabilized zirconia, an ytterbia-stabilized zirconia, a lanthana-stabilized zirconia, a gadolinia-stabilized zirconia, or a mixture thereof.

5. The coating system (102) as in any preceding claim, wherein the columnar TBC layer has a thickness of about 25 microns to about 2000 microns.

6. The coating system (102) as in claim 5, wherein the dense TBC layer has a thickness that is about half of the thickness of the columnar TBC layer, or less.

7. The coating system (102) as in either of claim 5 or 6, wherein the dense TBC layer has a thickness that is about 1/4^{th} to about 1/8^{th} of the thickness of the columnar TBC layer.

8. The coating system (102) as in any preceding claim, wherein the dense TBC layer has a porosity of about 0.1% to about 10%.

9. The coating system as in any preceding claim, further comprising:
a thermally grown oxide on the bond coating layer, wherein the thermally grown oxide is positioned between the bond coating layer and the dense TBC layer.

10. The coating system (102) as in any preceding claim, further comprising:
an intermediate dense layer positioned between the dense TBC layer and the columnar TBC layer.

11. The coating system (102) as in claim 10, wherein the intermediate dense layer is a gadolinium-containing intermediate dense layer.

12. The coating system (102) as in either of claim 10 or 11, wherein the intermediate dense layer has a porosity that is about 15% or less.

13. A method of forming a coating system (102) on a surface (115) of a substrate (120), the method comprising:
forming a dense TBC layer (145) on a bond coating layer (140) overlying a substrate (120), wherein the dense TBC layer comprises a ceramic material, and wherein the dense TBC layer is formed to a porosity of about 15% or less; and
applying a columnar TBC layer (110) on the dense TBC layer (145) such that the columnar TBC layer defines a plurality of elongated surface-connected voids (130).

14. The method as in claim 13, further comprising:
forming an intermediate dense layer on the dense TBC layer (145) prior to forming the columnar TBC layer (110).

15. The method as in claim 14, wherein the intermediate dense layer is a gadolinium-containing intermediate dense layer.
